# EUROPEAN PATENT APPLICATION

(11) **EP 2 799 963 A2**
(43) Date of publication of application: **05.11.2014**
(21) Application number: 14166259.3
(22) Date of filing: 28.04.2014
(51) Int. Cl.: G06F 3/042

(54) **Motion Sensing Device and Packaging Method thereof**

(30) Priority: 29.04.2013 US 201361817306 P; 26.12.2013 CN 201310731621
(71) Applicant: Lite-On Semiconductor Corporation, New Taipei City 231 (TW)
(72) Inventor: Hsieh, Ming-Hsun, 829 Kaohsiung City (TW)
(74) Representative: Becker Kurig Straus

(57) **Abstract**

A motion sensing device for sensing infrared rays, the motion sensing device including a substrate; a sensing unit for sensing the infrared rays which is configured on the substrate; a stabilizing layer for fixing and protecting the sensing unit by covering the sensing unit, wherein the stabilizing layer has an opening; a protection layer formed on the opening; and a coating layer for absorbing infrared rays by covering the stabilizing layer wherein the coating layer does not cover the opening.

## Description

### Field of the Invention

The present invention relates to a motion sensing device packaging method thereof, and more particularly, to a motion sensing device sensing movements and motions of an object by detecting infrared ray and packaging method thereof.

### Background of the Invention

Due to their scientific and technological advancement, computer systems are viewed as necessities for ordinary people in their daily lives, from traditional functions, such as word processing and program executing, to modern multimedia processing, and computer games, etc. Thus technology of the input apparatus also has improved.

A pointing device is utilized for transforming motions of a user into signals via a motion sensor capable of sensing a motion trace for an electronic device having computing capacity so as to control the movement of graphical cursers or pointers on display screens, to select objects on display screens with a graphical user interface, and to perform control functions displayed on the screen, allowing the user direct interaction with the computer system. Thus how to realize the motion sensor with high accuracy becomes a topic to be discussed.

### Summary of the Invention

With this in mind, the present application aims at providing a motion sensing device sensing movements and motions of an object by detecting infrared ray and at providing a packaging method thereof for solving the abovementioned problem.

This is achieved by motion sensing device sensing movements and motions of an object by detecting infrared ray and packaging method thereof according to claims 1 and 5. The dependent claims pertain to corresponding further developments and improvements.

As will be seen more clearly from the detailed description following herebelow, the claimed motion sensing device for sensing infrared rays comprises a substrate; a sensing unit for sensing the infrared rays configured on the substrate; a stabilizing layer for fixing and protecting the sensing unit by covering the sensing unit, wherein the stabilizing layer has an opening; a protection layer formed on the opening; and a coating layer for absorbing infrared rays by covering the stabilizing layer, wherein the coating layer does not cover the opening.

### Brief Description of the Drawings

FIG. 1 is a schematic diagram of a motion sensing device according to an embodiment of the present invention.
FIG. 2 is a schematic diagram of another motion sensing device according to another embodiment of the present invention.
FIG. 3 is a schematic diagram of a plurality of motion sensing devices according to another embodiment of the present invention.
FIG. 4 is a flow chart of a process according to an embodiment of the present invention.

### Detailed Description

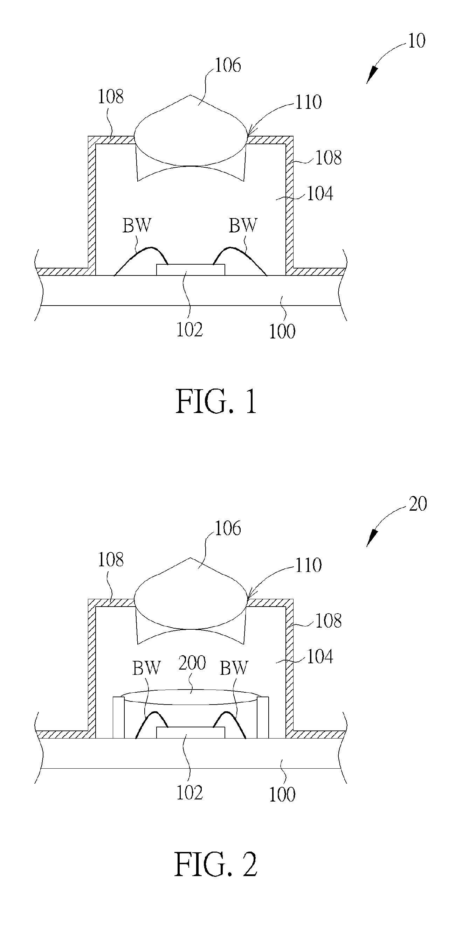

FIG. 1 is a cross-section view of a motion sensing device 10 according to an embodiment of the present invention. The motion device 10 comprises a substrate 100, a sensing unit 102, a stabilizing layer 104, a protection layer 106 and a coating layer 108. The sensing unit 100 is bonded to the substrate 100 for receiving the infrared rays and accordingly detecting the moving trace of the external object. The stabilizing layer 104 for fixing and protecting the sensing unit 102 covers the sensing unit 102. Further, the stabilizing layer 104 comprises an opening 10 for configuring the protection layer 106. The coating layer 108 is for preventing additional infrared rays from entering into the sensing unit 102 by covering the stabilizing layer 104. It is important to note that the coating layer 108 does not cover the opening 110 (i.e. does not block the path of the light from the opening 110 to the sensing unit 102) so as to ensure the motion sensing device 10 works normally. As a result, the motion sensing device 10 of this embodiment can sense the moving trace of the external object.

In details, the substrate 100 may be a printed circuit board (PCB) or a substrate formed by the lead frame, but is not limited herein. In FIG. 1, the sensing unit 102 is a chip bonded to the pads of the substrate 100 via a plurality of bonding wires for transmitting signals. Please note that FIG. 1 only shows two bonding wires BW for illustrations. The material of the pads and the bonding wires of the substrate 100 is conductive material such as gold, copper or aluminum. The stabilizing layer 104 covers the top of the sensing unit 102, and the material of the stabilizing layer 104 is a transparent glue, such as Silicone, an Epoxy, or an Ultraviolet light (UV) Curable Adhesive, which allows the infrared rays to pass through. Via a half cutting process, the opening 110 is formed on the top of the stabilizing layer 104. The protection layer 106 is formed on (e.g. injected to) the opening 110 of the stabilizing layer 104 and the material of the protection layer 106 is the transparent glue, such as the silicone, which allows the infrared rays to pass through.

Finally, since the operations of the sensing unit 102 senses the motions of the objects achieved via detecting the infrared rays, the sensing unit 102 is sensitive to the variations of infrared rays in the surrounding environment. In such a condition, the coating layer 108 containing materials for blocking the infrared rays is used to cover the stabilizing layer 104, for blocking the infrared rays within a certain frequency range and for preventing the sensing result of the sensing unit 102 from being affected. Please note that the coating layer does not cover the protection layer 106 (i.e. the opening 110) so as to ensure the path of the infrared rays enters to the sensing unit 102. Further, the method of forming the coating layer 108 may be selected from a variety. For example, the coating layer 108 may cover the outer side of the stabilizing layer 104 via a spin coating process. As a result, the sensing unit 102 can receive the infrared rays enterring from the opening 110, so as to sense the moving trace of the external object. For example, the light reflected by the external objects is changed due to different positions and different shapes of the external object. The motion sensing device 10 acquires the moving trace of the object via sensing the infrared rays reflected by the external object. In addition, the motion sensing device 10 may further comprise an infrared ray emitting unit (not shown in FIG. 1), for emitting the infrared rays capable of being sensed by the sensing unit 102, and is not limited herein.

Noticeably, the present invention provides a motion sensing device realized by the simple process. According to different applications and design concepts, those with ordinary skill in the art may observe appropriate alternations and modifications. For example, the wavelength of the light received by the sensing unit 102 for performing the operations of sensing the moving traces and motions of the objects can be altered to different wavelength ranges, such as the wavelength ranges of the UV and the visible light. Note that, when the wavelength range of the light received by the sensing unit 102 changes, the wavelength range of the light shielded by the coating layer 108 needs to be accordingly altered to avoid affecting the sensing result of the sensing unit 102.

FIG. 2 is a schematic diagram of a motion sensing device 20 according to an embodiment of the present invention. The motion sensing device 20 is similar to the motion sensing device 10 shown in FIG. 1, thus the components with similar functions use the same symbols. Different from the motion sensing device 10, the motion sensing device 20 adds a lens unit 200 at the top of the sensing unit 102. The lens unit 200 is utilized for focusing the light, to make the operations of the sensing unit 102 more efficient. According to different applications, the lens unit 200 can be lens component realized by different methods. For example, the lens unit 200 may be a wafer level lens, for reducing the manufacture cost by wafer level manufacturing technology.

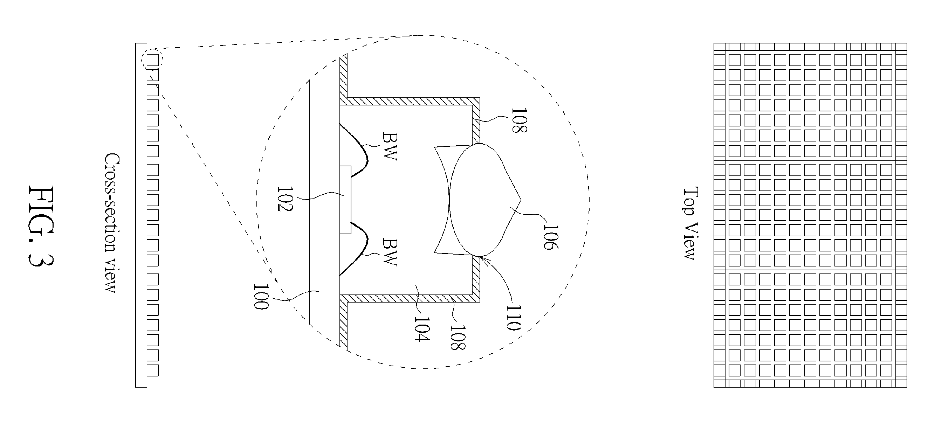

In the above embodiments, the single motion device is described to illustrate the structure and the packaging method. In general, when producing the packages of the motion sensing device, the entire packaging materials are configured layer by layer for generating multiple packages at the same time. Then, the multiple packages are sawed for acquiring multiple separate packages. FIG. 3 illustrates a top-view and a cross-section view of a plurality of motion sensing devices according to an embodiment of the present invention. According to different applications, the motion sensing device can be packaged by different packaging methods. For example, when packaging the motion sensing device, a sensing unit is configured on a substrate and bonded to the pads of the substrate via a plurality of bonding wires for forming the path of transmitting signals. Next, a stabilizing layer covers the sensing unit by performing the packing process. By performing the half-cutting process, the opening is formed on the top of the stabilizing layer. After the opening of the stabilizing layer is formed, the transparent glue (e.g. silicone) is injected to the opening for forming a protection layer at the opening. Finally, a coating layer covers the outer side of the stabilizing layer via performing the coating process (e.g. the spin-coating). Please note that, the coating layer does not cover the opening of the stabilizing layer. By performing the above steps, the plurality of packages (i.e. motion sensing devices) shown in FIG. 3 can be acquired. In FIG. 3, each square is a package and single motion sensing device can be acquired after cutting.

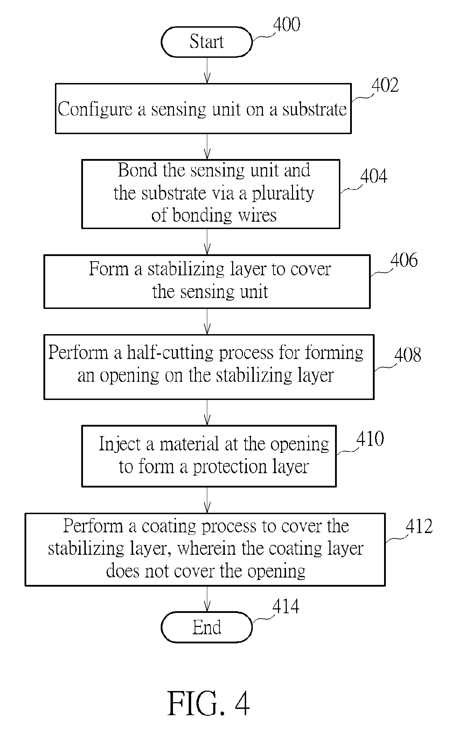

The method of packaging the motion sensing device can be summarized into a packing process 40, as shown in FIG. 4. The packaging process 40 comprises the following steps:
- Step 400:: Start.
- Step 402:: Configure a sensing unit on a substrate.
- Step 404:: Bond the sensing unit and the substrate via a plurality of bonding wires.
- Step 406:: Form a stabilizing layer to cover the sensing unit.
- Step 408:: Perform a half-cutting process for forming an opening on the stabilizing layer.
- Step 410:: Inject a material at the opening to form a protection layer.
- Step 412:: Perform a coating process to cover the stabilizing layer, wherein the coating layer does not cover the opening.
- Step 414:: End.

According to process 40, the plurality of motion sensing device shown in FIG. 3 can be acquired. After performing packaging cutting, the single motion sensing device can be acquired.

To sum up, the packaging method of the above embodiments uses the simple process to realize the motion sensing device sensing the moving traces of the object via detecting the infrared rays. The present invention can realize the motion sensing device with high accuracy with low cost.

## Claims

1. A motion sensing device (10) for sensing infrared rays, **characterized by** comprising:
a substrate (100);
a sensing unit (102) for sensing the infrared rays, bonded on the substrate (100);
a stabilizing layer (104) for fixing and protecting the sensing unit (102) by covering the sensing unit (102), wherein the stabilizing layer (104) has an opening (110);
a protection layer (106) formed on the opening (110); and
a coating layer (108) for absorbing infrared rays by covering the stabilizing layer (104), wherein the coating layer (108) does not cover the opening (110).

2. The motion sensing device of claim 1, **characterized in that** the motion sensing device further comprises:
a lens unit (200) configured on top of the sensing unit (102) and in the stabilizing layer (104).

3. The motion sensing device of claims 1 or 2, **characterized in that** the materials of the stabilizing layer (104) includes Silicone, Epoxy and/orUV curable adhesive.

4. The motion sensing device of any of claims 1-3, **characterized in that** the material of the protection layer (106) includes Silicone.

5. A packaging method of producing motion sensing device according to any of claims 1-4.

6. The packaging method of claim 5, **characterized in that** the packaging method comprises:
configuring a sensing unit (102) on a substrate (100);
bonding the sensing unit (102) and the substrate (100) via a plurality of bonding wires;
forming a stabilizing layer (104) which covers the sensing unit (102);
performing a half-cutting process to form an opening (110) on the stabilizing layer (104);
injecting a material at the opening (110) to form a protection layer (106); and
performing a coating process to cover the stabilizing layer (104) with a coating layer (108), wherein the coating layer (108) does not cover the opening (110).

7. The packaging method of claim 6, **characterized in that** after bonding the sensing unit (102) and the substrate (100) via the plurality of bonding wires, the packaging method further comprises:
configuring a lens unit (200) on top of the sensing unit (102).

8. The packaging method of claims 6 or 7, **characterized in that** the materials of the stabilizing layer (104) include Silicone, Epoxy and/or UV curable adhesive.

9. The packaging method of any of claims 6-8, **characterized in that** the material of the protection layer (106) includes Silicone.
